# FASCICULE DE BREVET EUROPEEN

(11) **EP 3 879 948 B1**
(45) Date de publication et mention de la délivrance du brevet: **12.06.2024**
(21) Numéro de dépôt: 21161504.2
(22) Date de dépôt: 09.03.2021
(51) Int. Cl.: H05K 7/14

(54) **BAIE ÉLECTRONIQUE ET VÉHICULE ÉQUIPÉ D'UNE TELLE BAIE**
ELEKTRONIKBUCHT UND FAHRZEUG, DAS MIT EINER SOLCHEN BUCHT AUSGESTATTET IST
ELECTRONIC RACK AND VEHICLE PROVIDED WITH SUCH A RACK

(30) Priorité: 11.03.2020 FR 2002407
(43) Date de publication de la demande: 15.09.2021
(73) Titulaire: ALSTOM Holdings, 93400 Saint-Ouen-sur-Seine (FR)
(72) Inventeur: ZANETTI, Adrien, 69100 VILLEURBANNE (FR)
(74) Mandataire: Lavoix

(56) Documents cités:
- FR-A1- 2 346 941
- FR-A1- 2 700 913
- FR-A1- 2 762 749
- US-A1- 2015 303 419
- US-A1- 2019 132 980

## Description

La présente invention concerne une baie électronique et un véhicule comportant une telle baie.

Des baies électroniques comportant un support et un ou plusieurs tiroirs contenant des modules électroniques amovibles sont utilisées dans de nombreuses applications. De telles baies permettent d'intégrer aisément les différents modules électroniques nécessaires par exemple au bon fonctionnement d'un véhicule ou d'une installation, tout en permettant un remplacement aisé des différents modules ou un ajout de modules additionnels, par exemple pour ajouter de nouvelles fonctions à l'installation ou au véhicule.

Les documents FR 2 346 941 A1, FR 2 762 749 A1, US 2015/303419 A1, US 2019/132980 A1 et FR 2 700 913 A1 divulguent des baies électroniques.

Ces baies comportent en général une face avant à travers laquelle les tiroirs sont insérés, la connexion électrique des différents modules étant assurée par des premiers connecteurs électriques dépassant d'une face arrière du tiroir. Ainsi, les câbles reliés à ces premiers connecteurs pour connecter les modules, soit entre eux, soit avec d'autres dispositifs disposés hors de la baie, sont disposés à l'arrière de la baie. Cela évite que les câbles soient déconnectés par accident en cas de passage d'une personne à proximité de la baie, et évite également que les premiers connecteurs électriques soient accessibles depuis l'avant de la baie, avec les risques d'électrisation associés. Les différents câbles sont équipés chacun d'un deuxième connecteur destiné à coopérer avec un premier connecteur d'un module électronique du tiroir pour relier le câble au module électronique.

Cependant, la grande dimension des tiroirs fait que pour qu'un opérateur puisse insérer ou retirer les tiroirs aisément, il est nécessaire de prévoir un jeu significatif entre le tiroir et le support. En effet, il est difficile pour un opérateur d'exercer une force parfaitement orientée de manière à empêcher tout pivotement du tiroir par rapport au support. En l'absence de jeu, le tiroir risquerait de se coincer fréquemment dans le support pendant son déplacement par un opérateur. En outre, les tiroirs contenant un grand nombre de modules électroniques peuvent être relativement lourds, ce qui limite encore la précision du travail de l'opérateur.

Afin d'éviter qu'une telle désorientation conduise soit à un mauvais contact entre les premiers et deuxièmes connecteurs, soit à un endommagement d'un de ces connecteurs, chaque deuxième connecteur est en général monté sur le support de manière flottante, afin de permettre un mouvement relatif entre le deuxième connecteur et le tiroir. Ainsi, chaque deuxième connecteur peut s'adapter au positionnement du premier connecteur correspondant.

Toutefois, de tels arrangements sont complexes à mettre en place et à entretenir. En outre, le tiroir est susceptible d'entraîner une dégradation des premiers ou deuxièmes connecteurs s'il est mal positionné lors de son insertion, du fait de sa masse qui requiert une force relativement importante pour le déplacer et lui confère une inertie importante.

Il existe donc un besoin pour une baie électronique qui soit plus simple et qui soit moins susceptible d'être endommagée que les baies électroniques de l'état de la technique.

A cet effet, il est proposé une baie électronique conforme à la revendication 1.

Grâce à l'invention, les connecteurs portés par le panneau sont connectés au tiroir en déplaçant le panneau, le tiroir étant dans sa position insérée. Les forces mises en jeu sont donc moindres que les forces nécessaires à déplacer le tiroir lui-même, ce qui limite les risques d'endommagement des différents connecteurs.

Selon des modes de réalisation particuliers, la baie présente une ou plusieurs des caractéristiques des revendications 2 à 12, prise(s) isolément ou selon toutes les combinaisons techniquement possibles.

Il est également proposé un véhicule conforme à la revendication 12.

Des caractéristiques et avantages de l'invention apparaîtront à la lecture de la description qui va suivre, donnée uniquement à titre d'exemple non limitatif, et faite en référence aux dessins annexés, sur lesquels :
[Fig 1] la figure 1 est une vue en perspective éclatée partielle d'une baie selon l'invention, comportant un support et un panneau,
[Fig 2] la figure 2 est une autre vue en perspective partielle de la baie de la figure 1,
[Fig 3] la figure 3 est une vue en perspective partielle du support et du panneau de la figure 1,
[Fig 4] la figure 4 est une vue en perspective agrandie du panneau de la figure 1,
[Fig 5] la figure 5 est une vue agrandie de la zone V de la figure 2,
[Fig 6] la figure 6 est une vue en coupe partielle de la baie de la figure 1,
[Fig 7] la figure 7 est une vue agrandie de la zone VII de la figure 6 après un déplacement relatif du panneau et du support, et
[Fig 8] la figure 8 est une autre vue agrandie de la zone VII de la figure 6 après un déplacement relatif additionnel du panneau et du support.

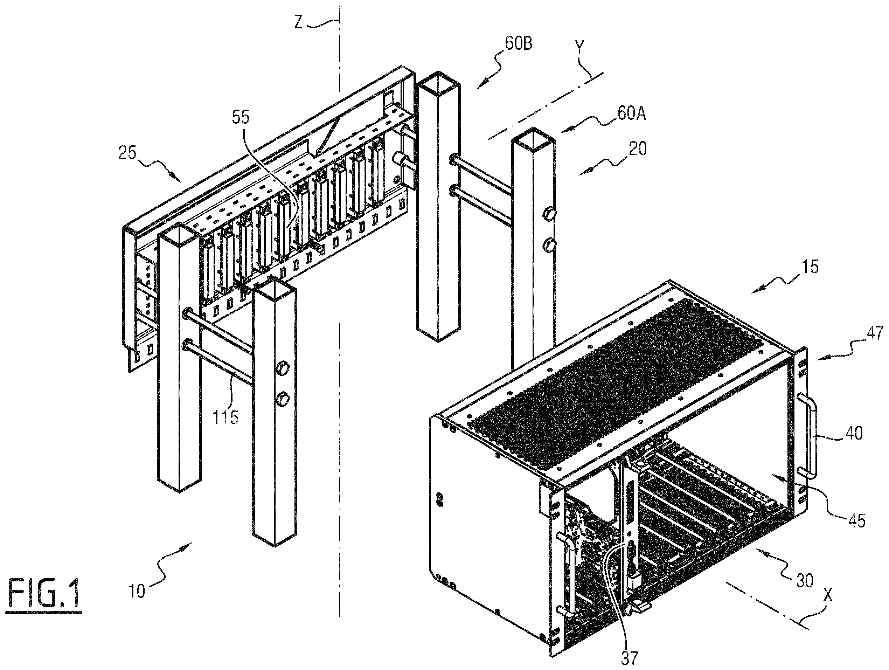

Une baie électronique 10 est représentée partiellement sur la figure 1.

La baie 10 est, par exemple, accueillie dans un véhicule, notamment un véhicule de transport en commun tel qu'un train, un tramway, un navire ou un avion.

La baie 10 comporte un tiroir 15, un support 20, un panneau 25 et des moyens 27 de déplacement du panneau 25.

Il est défini pour la baie 10 une direction verticale Z, une direction principale X et une direction transversale Y. La direction verticale Z est une direction verticale lorsque la baie est disposée dans le véhicule, ce véhicule étant en déplacement selon une direction horizontale. Les directions principale X et transversale Y sont perpendiculaires l'une à l'autre et sont chacune perpendiculaire à la direction verticale Z.

Il est défini un avant et un arrière pour la direction principale X.

Le tiroir 15 est configuré pour être accueilli dans le support 20 dans une position insérée. En particulier, le tiroir 15 est configuré pour être inséré dans le support 20, depuis l'extérieur du support 20 jusqu'à la position insérée, par un mouvement de translation depuis l'avant vers l'arrière.

Le tiroir 15 présente une face avant 30 et une face arrière 35.

Lorsque le tiroir 15 est dans la position insérée, la face avant 30 et la face arrière 35 délimitent le tiroir 15 selon la direction principale X.

Le tiroir 15 est, par exemple, réalisé en un matériau métallique tel que l'acier, notamment l'acier inoxydable, ou encore en aluminium pour un gain de poids.

Le tiroir 15 est, par exemple, sensiblement parallélépipédique. En particulier, la face avant et la face arrière 35 sont chacune perpendiculaire à la direction principale X lorsque le tiroir est dans la position insérée.

Avantageusement, le tiroir 15 est de format 19 pouces et de dimensions totalement ou partiellement conforme à la norme CEI 60297-3-101 ou NF F 61-005 ou IEEE 1101.1.

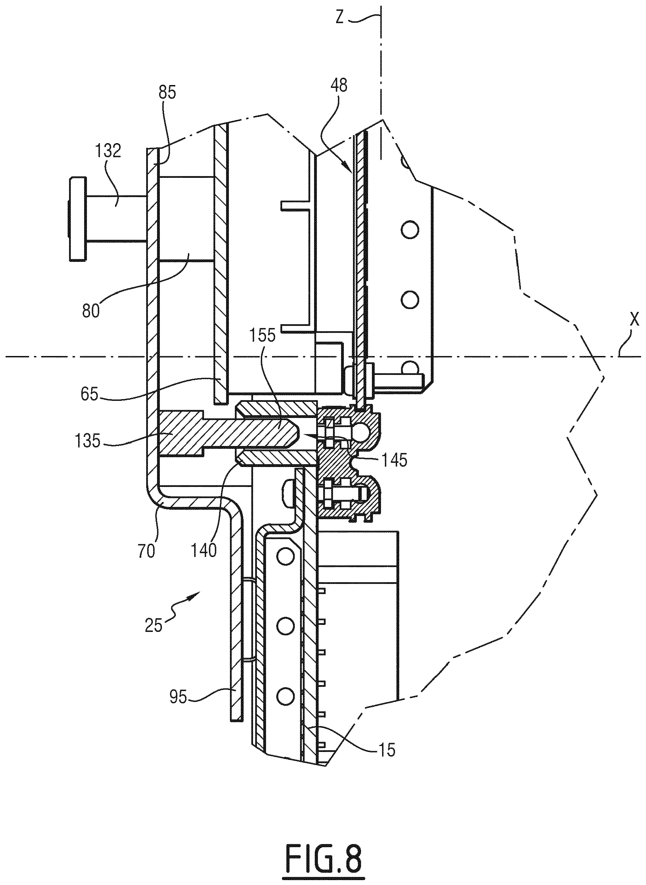

Le tiroir 15 est configuré pour accueillir au moins un module électronique 37, par exemple une pluralité de modules électroniques 37. Dans l'exemple de baie 10 représenté sur les figures 1 à 8, le tiroir 15 est configuré pour accueillir 12 modules électroniques 37, toutefois ce nombre est susceptible de varier.

De manière connue en soi, le tiroir 15 délimite par exemple une pluralité d'emplacements prévus chacun pour accueillir un module électronique 37 dans une position prédéterminée, et comporte notamment des moyens de fixation de chaque module électronique 37 dans la position prédéterminée.

Les emplacements sont, par exemple, décalés l'un par rapport à l'autre selon la direction transversale Y, de sorte que les modules électroniques 37 accueillis dans le tiroir 15 sont disposés successivement le long d'une ligne droite parallèle à la direction transversale Y. Toutefois, il est à noter que la disposition des modules 37 dans le tiroir 15 est susceptible de varier.

La face avant 30 est prévue pour être accessible par un opérateur lorsque le tiroir 15 est dans la position insérée.

La face avant 30 comporte, par exemple, au moins une poignée 40 configurée pour permettre à un opérateur de déplacer le tiroir 15 selon la direction principale X, par exemple deux poignées 40.

La face avant 30 délimite au moins une première ouverture 45 configurée pour permettre à un opérateur d'insérer au moins un module électronique 37, à travers l'ouverture 45, dans le tiroir 15.

La face avant 30 comporte, par exemple, des moyens de fixation du tiroir 15 au support 20, notamment des ouvertures 47 de réceptions de vis pour fixer le tiroir 15 au support 20.

La face arrière 35 est configurée pour que chaque module électronique 37 accueilli dans le tiroir 15 soit accessible depuis l'extérieur du tiroir 15 à travers la face arrière 35. En particulier, la face arrière 35 comporte au moins une ouverture 48, par exemple une pluralité d'ouvertures 48, chaque ouverture étant alignée avec un module électronique 37 correspondant lorsque ce module électronique 37 est accueilli dans le tiroir 15.

Chaque module électronique 37 est, de manière connue en soi, configuré pour traiter des données sous forme de signaux électriques.

De tels modules électroniques 37 sont susceptibles de remplir un grand nombre de fonctions. Par exemple, un module électronique 37 est configuré pour recevoir des valeurs mesurées par un capteur, pour détecter un dysfonctionnement du véhicule à partir des valeurs mesurées, et pour générer un message d'alerte lorsqu'un dysfonctionnement est détecté.

Chaque module électronique 37 comporte, par exemple, un processeur et une mémoire comportant des instructions logicielles destinées à être exécutées sur le processeur pour mettre en oeuvre un procédé remplissant une fonction du module électronique 37. En variante, le processeur et la mémoire sont par exemple remplacés par un circuit intégré dédié ou encore par un ensemble de composants logiques programmables.

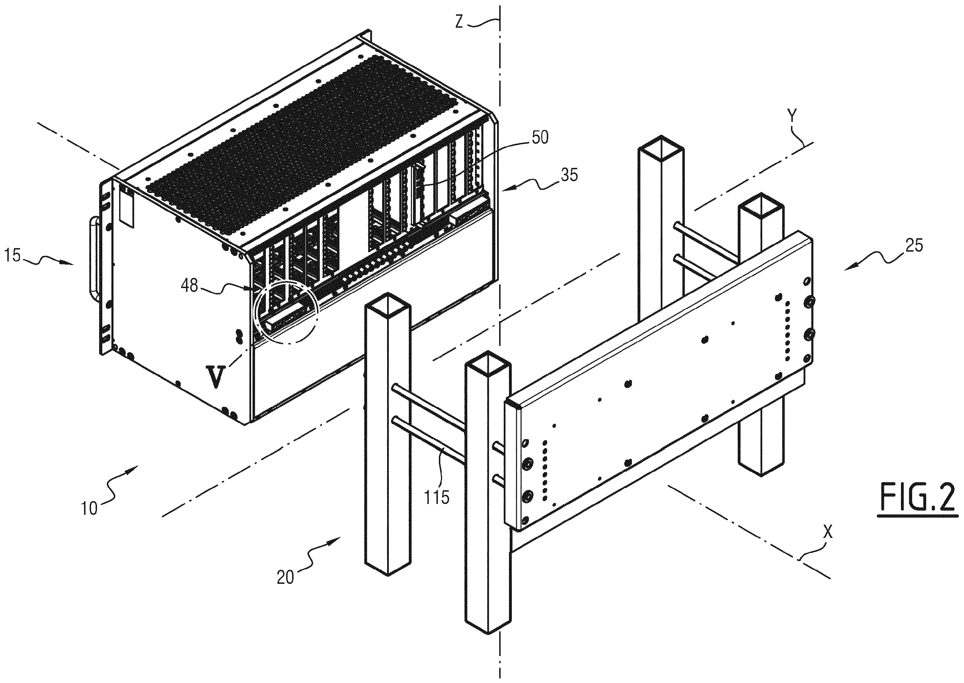

Chaque module électronique 37 comporte un connecteur 50 destiné à être connecté à un connecteur 55 du panneau 25, comme expliqué ci-dessous. Un connecteur 50 est visible sur la figure 2.

Les connecteurs 50 et 55 sont, par exemple, des connecteurs électriques destinés à échanger des signaux sous forme de courants électriques. En variante, les connecteurs 50 et 55 sont des connecteurs optiques destinés à échanger des signaux lumineux. De nombreux types de connecteurs 50, 55 électriques ou optiques sont susceptibles d'être utilisés.

Les connecteurs 50 et 55 sont notamment configurés pour être connectés deux à deux par un mouvement de translation selon la direction principale X.

Le support 20 est configuré pour supporter le tiroir 15. En particulier, le support 20 est configuré pour accueillir le tiroir 15 dans une position insérée et pour guider le tiroir 15 en translation depuis l'extérieur du support 20 selon la direction principale X.

Par exemple, le support 20 comporte, de manière connue, une ou plusieurs glissières configurée(s) pour supporter le poids du tiroir 15 et pour guider le tiroir 15 en translation selon la direction principale X. De telles glissières sont connues en soi et ne sont pas représentées sur les figures.

Le support 20 comporte, par exemple, un ensemble de piliers 60A, 60B, par exemple quatre piliers 60A, 60B.

Chaque pilier 60A, 60B s'étend par exemple selon la direction verticale Z. En particulier, chaque pilier 60A, 60B est configuré pour être posé sur un sol du véhicule ou pour être fixé à un plafond du véhicule.

Chaque pilier 60A, 60B présente, par exemple, une section rectangulaire ou carrée perpendiculairement à la direction verticale, toutefois la forme des piliers 60 est susceptible de varier.

Les piliers 60A, 60B sont, par exemple, au nombre de quatre, toutefois ce nombre est susceptible de varier.

Une plaque s'étendant horizontalement, interposée entre les piliers 60A, 60B et fixée à chaque pilier 60A, 60B est un exemple de glissière propre à supporter le tiroir 15. Deux glissières présentant chacune une section en forme de « L » et s'étendant chacune selon la direction principale X sont un autre exemple de glissières configurées pour supporter et guider en translation le tiroir 15.

L'ensemble de piliers 60A, 60B comporte, par exemple, deux premiers piliers 60A et deux deuxièmes piliers 60B.

Les deux premiers piliers 60A sont décalés l'un par rapport à l'autre selon la direction transversale Y. Une distance entre les premiers piliers 60A est, par exemple, comprise entre 200 millimètres (mm) et 500 mm.

Les deux deuxièmes piliers 60B sont décalés l'un par rapport à l'autre selon la direction transversale Y. Une distance entre les deuxièmes piliers 60B est, par exemple, comprise entre 200 mm et 500 mm.

Les piliers 60A, 60B sont, par exemple, disposés chacun à un sommet d'un rectangle compris dans un plan horizontal. Dans ce cas, les premiers piliers 60A sont disposés aux extrémités d'un premier côté du rectangle, les deuxièmes piliers 60B étant disposés aux extrémités d'un deuxième côté du rectangle, parallèle au premier côté.

Chaque premier pilier 60A est décalé par rapport à un deuxième pilier 60B correspondant selon la direction principale X. Ainsi, ces deux piliers 60A, 60B sont disposés chacun à une extrémité d'un côté du rectangle perpendiculaire aux premier et deuxième côtés.

Une distance, selon la direction principale X, entre chaque premier pilier 60A et le deuxième pilier 60B correspondant, est comprise par exemple entre 200 mm et 400 mm.

Lorsque le tiroir 15 est dans la position insérée, le tiroir 15 est interposé entre les deux premiers piliers 60A selon la direction transversale Y. En outre, lorsque le tiroir 15 est dans la position insérée, le tiroir 15 est interposé entre les deux deuxièmes piliers 60B selon la direction transversale Y.

Chaque pilier 60A, 60B comporte au moins un trou, par exemple deux trous, traversant le pilier 60A, 60B selon la direction principale X. Chaque trou présente un premier diamètre compris entre 5 mm et 10 mm.

En particulier, chaque trou d'un premier pilier 60A est coaxial avec un trou correspondant du deuxième pilier 60B par rapport auquel le premier pilier 60A considéré est décalé selon la direction principale X.

Une distance, selon la direction verticale Z, entre les axes des deux trous d'un même pilier 60A, 60B, est par exemple comprise entre 40 mm et 500 mm.

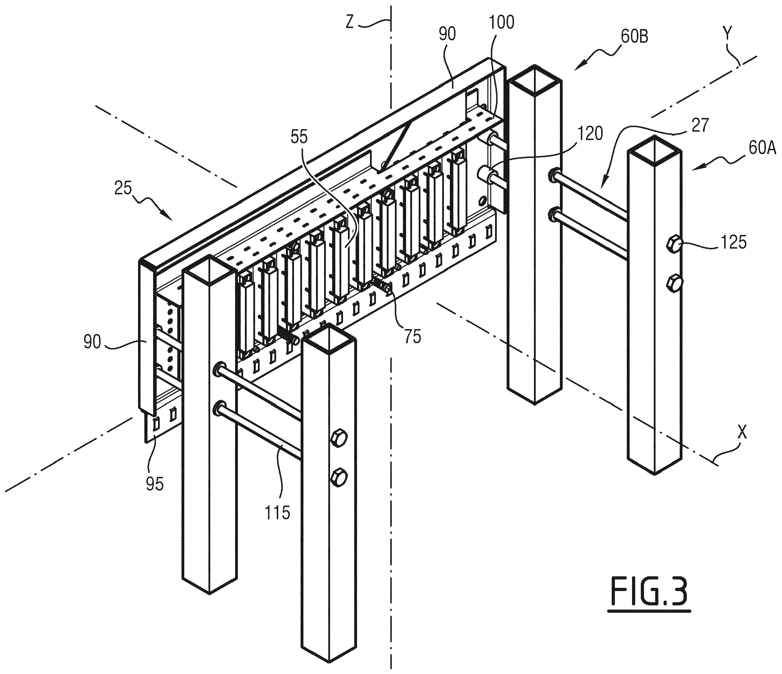

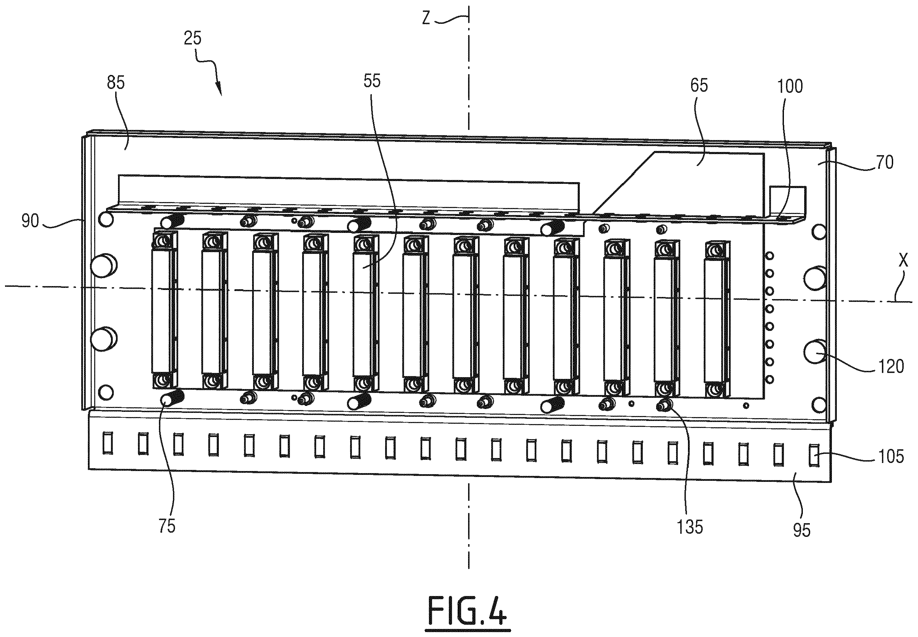

Le panneau 25 est représenté en détails sur la figure 3 et la figure 4.

Le panneau 25 est disposé en regard de la face arrière 35 du tiroir 15.

Le panneau 25 est mobile entre une première et une deuxième position. Le panneau 25 est représenté dans sa première position sur les figures 1 à 3. En particulier, le panneau 25 est mobile selon la direction principale X entre les première et deuxième positions. Par exemple, le panneau 25 est mobile en translation selon la direction principale X entre les première et deuxième positions.

Une distance entre la première et la deuxième position, mesurée selon la direction principale X, est par exemple comprise entre 5 mm et 30 mm. Cette distance est mesurée entre un point du panneau 25 lorsque le panneau 25 est dans la première position, et le même point lorsque le panneau 25 est dans la deuxième position.

Le panneau 25 comporte au moins un deuxième connecteur 55, notamment un ensemble de deuxièmes connecteurs 55, une carte 65, un châssis 70 et optionnellement au moins un éjecteur 75 et/ou un organe de connexion.

Le panneau 25 est sensiblement perpendiculaire à la direction principale X.

Lorsque le panneau 25 est dans la première position, le panneau 25 présente un jeu mécanique, par rapport au support 20, dans un plan perpendiculaire à la direction principale X, supérieur ou égal à 1 mm.

En d'autres termes, la baie 10 est configurée pour permettre, lorsque le panneau 25 est dans la première position, un mouvement relatif du panneau 25 par rapport au support 20, selon une direction perpendiculaire à la direction principale X, supérieur ou égal à 1 mm. Le jeu mécanique est, par exemple, compris entre 2 mm et 4 mm.

Le panneau 25 comporte au moins un deuxième connecteur 55 pour chaque emplacement destiné à accueillir un module électronique 37 du tiroir 15. Par exemple, comme visible sur la figure 4, le panneau 25 comporte 12 deuxièmes connecteurs 55, cependant ce nombre est susceptible de varier.

Lorsque le panneau 25 est dans la première position, chaque deuxième connecteur 55 est déconnecté du premier connecteur 50 correspondant. Lorsque le panneau 25 est dans la deuxième position, chaque deuxième connecteur 55 est connecté au premier connecteur 50 correspondant, si ce premier connecteur 50 est présent.

Chaque deuxième connecteur 55 est disposé en regard d'un premier connecteur correspondant lorsque le panneau est dans la deuxième position et le tiroir 15 est dans la position insérée.

Par exemple, les deuxièmes connecteurs 55 sont disposés successivement le long d'une droite parallèle à la direction transversale Y. Une distance entre deux deuxièmes connecteurs 55 consécutifs, c'est-à-dire deux deuxièmes connecteurs 55 qui ne sont pas séparés l'un de l'autre par un autre deuxième connecteur 55, est par exemple uniforme. Notamment la distance entre deux deuxièmes connecteurs 55 consécutifs est comprise entre 5 mm et 50 mm.

Chaque deuxième connecteur 55 est porté par la carte 65.

La carte 65 est réalisée en un matériau électriquement isolant tel qu'une résine epoxy constituant le substrat d'un circuit imprimé.

La carte 65 est perpendiculaire à la direction principale X lorsque le panneau 25 est dans la deuxième position.

La carte 65 est disposée en avant du châssis 70. En particulier, la carte 65 est interposée selon la direction principale X entre le châssis 70 et le tiroir 15.

La carte 65 comporte, par exemple, au moins une piste de conduction. Chaque piste de conduction est portée par une face de la carte 65, notamment par la face de la carte 65 qui est en regard du châssis 70, en d'autres termes la face arrière de la carte 65, ou est portée en couche interne du circuit imprimé.

Chaque piste de conduction relie électriquement entre eux deux deuxièmes connecteurs 55. Par exemple, un premier module électronique 37 est une alimentation électrique, reliée ainsi électriquement à un second module électronique 37, ce second module 37 étant un processeur de calcul.

Chaque piste de conduction est réalisée en un matériau électriquement conducteur, par exemple en cuivre.

La carte 65 est, par exemple, fixée au châssis 70 par des colonnettes 80 interposées selon la direction principale X entre le châssis 70 et la carte 65. Chaque colonnette 80 est réalisée en un matériau électriquement isolant tel que du nylon, ou avantageusement dans un matériau conducteur tel que de l'inox pour faire une reprise de masse de la carte 65 sur le châssis 70.

Chaque colonnette 80 est en appui contre le châssis 70 et contre la carte 65. Chaque colonnette 80 présente une longueur, mesurée selon la direction principale X, comprise entre 2 mm et 20 mm.

Le châssis 70 est réalisé en un matériau électriquement conducteur tel qu'un matériau métallique. Par exemple, le châssis 70 est réalisé en un acier, notamment l'acier inoxydable.

Le châssis 70 est configuré pour supporter la carte 65, par exemple par l'intermédiaire des colonnettes 80, bien que d'autres moyens de fixation de la carte 65 au châssis 70 soient envisageables.

Le châssis 70 est, par exemple, disposé en arrière de la carte 65.

Le châssis 70 comporte, par exemple, une portion principale 85, au moins une portion latérale 90, par exemple quatre portions latérales 90, une portion secondaire 95 et une portion tertiaire 100.

La portion principale 85 est perpendiculaire à la direction principale X lorsque le panneau 25 est dans la deuxième position.

La portion principale 85 supporte la carte 65, par exemple par l'intermédiaire des colonnettes 80.

La carte 65 est interposée entre la portion principale 85 et le tiroir 15.

Une projection de la carte 65 sur un plan perpendiculaire à la direction principale X est incluse dans une projection de la portion principale 85 sur ce plan. En d'autres termes, la portion principale 85 s'étend au-delà de la carte 65 dans un plan perpendiculaire à la direction principale X. Ainsi, la projection de la carte 65 sur la portion principale 85, selon la direction principale X, est entourée par un pourtour de la portion principale 85.

La portion principale 85 est, par exemple, rectangulaire.

Les portions latérales 90, ensemble, entourent la portion principale 85. Par exemple, chaque portion latérale 90 s'étend à partir de la portion principale 85 selon la direction principale X. Ainsi, la portion principale 85 et les portions latérales 90, ensemble, délimitent une cavité de réception de la carte 65.

Chaque portion latérale 90 est, par exemple, perpendiculaire à la direction verticale Z ou à la direction transversale Y.

Chaque portion latérale 90 est, par exemple, rectangulaire.

Chaque portion latérale 90 présente une longueur, mesurée selon la direction principale X, comprise entre 10 mm et 50 mm. La longueur de chaque portion latérale 90 est, notamment, supérieure ou égale à la distance, selon la direction principale X, entre la carte 65 et la portion principale 85.

La portion secondaire 95 s'étend à partir de l'une des portions latérales 90 selon la direction verticale Z. En particulier, la portion secondaire 95 s'étend vers le bas à partir de la portion latérale 90 qui délimite une extrémité inférieure de la portion principale 85.

La portion secondaire 95 présente une longueur, mesurée selon la direction verticale Z, comprise par exemple entre 20 mm et 30 mm.

Une distance entre la portion secondaire 95 et la face arrière 35 du tiroir 15, lorsque le tiroir 15 est dans la position insérée et le panneau 25 est dans la deuxième position, est inférieure ou égale à 5 mm.

La portion secondaire 95 est, par exemple, rectangulaire.

La portion secondaire 95 est perpendiculaire à la direction principale X.

La portion secondaire 95 présente, par exemple, un ensemble de saillies 105.

Les saillies 105 sont, par exemple, disposées successivement le long d'un segment de droite parallèle à la direction transversale Y. Chaque saillie 105 s'étend à partir d'une face de la portion secondaire 95 selon la direction principale X.

En particulier, chaque saillie 105 est interposée entre la face considérée et le tiroir 15 lorsque le tiroir 15 est dans la position insérée. Par exemple, chaque saillie 105 est en appui contre le tiroir 15, notamment contre la face arrière 35, lorsque le tiroir 15 est dans la position insérée et le panneau 25 est dans la deuxième position.

Une distance entre deux saillies 105 consécutives est comprise entre 12 mm et 100 mm. Cette distance est, par exemple, identique pour toutes les paires de saillies 105 consécutives.

Par exemple, chaque saillie 105 présente une largeur, mesurée selon la direction transversale Y, comprise entre 2 mm et 5 mm, un décalage spatial, selon la direction transversale Y, entre deux saillies 105 consécutives étant compris entre 12 mm et 100 mm.

Chaque saillie 105 présente, par exemple, une forme rectangulaire dans un plan perpendiculaire à la direction principale X.

Le nombre de saillies 105 est, par exemple, choisi de telle sorte qu'une distance entre une extrémité, selon la direction transversale Y, et la saillie 105 la plus proche de l'extrémité considérée, est inférieure ou égale à la distance entre deux saillies 105 consécutives.

Une hauteur de chaque saillie 105, mesurée à partir d'une face de la portion secondaire 95, est comprise entre 0.5 mm et 10 mm.

La portion principale 85, chaque portion latérale 90 et la portion secondaire 95 sont par exemple venues de matière entre elles. En particulier, la portion principale 85, chaque portion latérale 90 et la portion secondaire 95 sont formées par pliage d'une unique plaque métallique.

La portion tertiaire 100 s'étend, à partir de la portion principale 85, selon la direction principale X vers l'avant de la baie 10. En particulier, la carte 65 est interposée entre la portion tertiaire 100 et la portion secondaire 95.

Une longueur de la portion tertiaire 100, mesurée selon la direction principale X, est comprise entre 20 mm et 30 mm.

Une largeur de la portion tertiaire 100, mesurée selon la direction transversale Y, est comprise entre 200 mm et 400 mm. En particulier, la largeur de la portion tertiaire 100 est supérieure ou égale à une largeur, selon la même direction Y, de la carte 65.

La portion tertiaire 100 présente, par exemple, un ensemble de saillies 110.

Les saillies 110 sont, par exemple, disposées successivement le long d'un segment de droite parallèle à la direction transversale Y. Chaque saillie 110 s'étend à partir d'une face de la portion tertiaire 100 selon la direction verticale Z.

En particulier, chaque saillie 110 est interposée entre la face considérée et le tiroir 15 lorsque le tiroir 15 est dans la position insérée. Par exemple, chaque saillie 110 est en appui contre le tiroir 15, notamment contre une face supérieure du tiroir 15, lorsque le tiroir 15 est dans la position insérée et le panneau 25 est dans la deuxième position.

Une distance entre deux saillies 110 consécutives est comprise entre 12 mm et 100 mm. Cette distance est, par exemple, identique pour toutes les paires de saillies 110 consécutives.

Par exemple, chaque saillie 110 présente une largeur, mesurée selon la direction transversale Y, comprise entre 2 mm et 5mm, un décalage spatial, selon la direction transversale Y, entre deux saillies 105 consécutives étant compris entre 12 mm et 100 mm.

Chaque saillie 110 présente, par exemple, une forme rectangulaire dans un plan perpendiculaire à la direction verticale Z.

Le nombre de saillies 110 est, par exemple, choisi de telle sorte qu'une distance entre une extrémité, selon la direction transversale Y, et la saillie 110 la plus proche de l'extrémité considérée, est inférieure ou égale à la distance entre deux saillies 105 consécutives.

Une hauteur de chaque saillie 110, mesurée à partir d'une face de la portion tertiaire 100, est comprise entre 0,5 mm et 100 mm.

Selon une variante, au moins une saillie 105, 110 n'est pas en appui contre le tiroir 15 lorsque le panneau 25 est dans la deuxième position et le tiroir 15 est dans la position insérée. Dans ce cas, le tiroir 15 comporte un élément élastique tel qu'un ressort, par exemple un ressort hélicoïdal ou encore une lame ressort, réalisé en un matériau électriquement conducteur, et configuré pour venir en appui contre la saillie 105, 110 lorsque le panneau 25 est dans la deuxième position et le tiroir 15 est dans la position insérée.

Les saillies 105, 110 et le châssis 70 constitue ainsi un blindage électromagnétique autour de la carte 65 en créant un contact sur le tiroir 15 lorsque ce dernier est dans la position insérée et le panneau est dans la deuxième position.

Chaque éjecteur 75 est configuré pour exercer sur le panneau 25 une force tendant à déplacer le panneau 25 de la deuxième position jusqu'à la première position.

Par exemple, le panneau 25 comporte quatre éjecteurs 75 encadrant la carte 65 selon la direction verticale Z. En particulier, le panneau 25 comporte deux paires d'éjecteurs 75, la carte 65 étant interposée entre les deux paires selon la direction verticale Z.

Les deux éjecteurs 75 d'une même paire sont notamment alignés l'un avec l'autre selon la direction transversale Y.

Une distance, selon la direction transversale Y, entre deux éjecteurs 75 d'une même paire est par exemple comprise entre 100 mm et 300 mm.

En outre, chaque éjecteur 75 d'une paire est, par exemple, aligné selon la direction verticale Z avec un éjecteur 75 de l'autre paire.

Une distance, selon la direction verticale Z entre les deux paires d'éjecteurs 75 est par exemple comprise entre 100 mm et 300 mm.

Il est à noter que d'autres configurations sont possibles pour les différents éjecteurs 75.

Chaque éjecteur 75 comporte un organe élastique configuré pour exercer une force tendant à déplacer le panneau 25 de sa deuxième position vers sa première position.

Chaque éjecteur 75 comporte, par exemple, un élément d'appui télescopique destiné à venir en appui contre le tiroir 15 lorsque le panneau 25 est dans la deuxième position et le tiroir 15 est dans la position insérée, et un ressort configuré pour déplacer l'élément d'appui vers une configuration étendue depuis une configuration rétractée.

L'élément télescopique comporte un élément mobile selon la direction principale X entre la configuration rétractée et la configuration étendue, et un élément de guidage en translation de l'élément mobile selon la direction principale X. Le ressort exerce sur l'élément mobile une force tendant à déplacer l'élément mobile depuis une position correspondant à la configuration rétractée jusqu'à une position correspondant à la configuration étendue.

L'élément télescopique est dans la configuration rétractée, en appui contre le tiroir 15, lorsque le panneau 25 est dans la deuxième position et le tiroir 15 est dans la position insérée.

L'élément télescopique est dans la configuration étendue lorsque le panneau 25 est dans la première position. En particulier, l'élément télescopique n'est pas en appui contre le tiroir 15 lorsque le panneau 25 est dans la première position. Par exemple, une course de l'élément mobile entre la configuration rétractée et la configuration étendue est strictement inférieure à la distance entre la première et la deuxième position selon la direction principale X.

En variante, l'éjecteur 75 comporte un pion et un ressort enroulé autour du pion. Le pion est reçu dans un orifice du tiroir 15 lorsque le panneau 25 est dans la deuxième position et le tiroir 15 est dans la position insérée. Le ressort est configuré pour venir en appui contre le tiroir 15 lorsque le panneau 25 est dans la deuxième position et le tiroir 15 est dans la position insérée.

Il est à noter que de nombreux types d'éjecteurs sont susceptibles d'être utilisés.

L'organe de connexion est connecté, par exemple via des pistes conductrices de la carte 65 ou via des conducteurs indépendants de la carte 65, à chaque deuxième connecteur 55. En variante, l'organe de connexion est connecté à au moins un deuxième connecteur 55 par un guide d'onde optique tel qu'une fibre optique.

L'organe de connexion est configuré pour être connecté à un ensemble de câbles, et pour relier chaque câble à l'un des deuxièmes connecteurs 55.

Chaque câble est prévu pour conduire des signaux, par exemple des signaux électriques ou optiques, entre un dispositif extérieur à la baie 10 et un module électronique 37.

Les moyens de déplacement 27 sont configurés pour déplacer le panneau 25 selon la direction principale X entre la première position et la deuxième position, notamment pour déplacer le panneau 25 en translation entre les première et deuxième positions.

Les moyens de déplacement 27 comportent, par exemple, au moins un tirant 115. En particulier, les moyens de déplacement 27 comportent au moins une paire de tirants 115, par exemple deux paires de tirants 115.

Il est à noter que des moyens de déplacement 27 dépourvus de tirants sont également susceptibles d'être envisagés.

Le tiroir 15 est, par exemple, interposé dans un plan perpendiculaire à la direction principale X entre les deux tirants 115 de chaque paire.

Les moyens de déplacement 27 comportent, en outre, pour chaque tirant 27, un organe 120 complémentaire du tirant 27.

Chaque tirant 115 s'étend selon un axe parallèle à la direction principale X. Chaque tirant 115 est accueilli dans au moins un trou d'un pilier 60A, 60B correspondant, en particulier dans deux trous coaxiaux ménagés chacun dans un premier pilier 60A ou deuxième pilier 60B, chaque trou traversant le premier ou deuxième pilier 60A, 60B considéré selon la direction principale X.

Chaque tirant 115 est, par exemple, cylindrique. En particulier, chaque tirant 115 présente un deuxième diamètre strictement inférieur au premier diamètre des trous dans lesquels le tirant 115 est accueilli. Une différence entre le premier diamètre et le deuxième diamètre est notamment supérieure ou égale à 1 mm, notamment comprise entre 2 mm et 4 mm.

Chaque tirant 115 est configuré pour exercer sur le panneau 25 une force tendant à déplacer le panneau 25 de la première à la deuxième position ou vice-versa. En particulier, chaque tirant 115 est configuré pour exercer sur chacun du panneau 25 et d'un pilier 60A, 60B, notamment sur un premier pilier 60A, une force tendant à éloigner le panneau 25 du pilier 60A, 60B ou à rapprocher le panneau 25 du pilier 60A, 60B.

Par exemple, chaque tirant 115 est configuré pour pivoter autour de son axe par rapport au panneau 25 et à chaque pilier 60A, 60B.

Les moyens de déplacement 27 comportent par exemple pour chaque tirant 115 une tête 125 solidaire du tirant 115.

La tête 125 est en appui contre le premier pilier 60A traversé par le tirant 115.

La tête 125 est disposée à une première extrémité du tirant 115. En particulier, le premier pilier 60A est interposé entre la tête 125 et le panneau 25.

La tête 125 présente une forme prévue pour permettre à un opérateur de faire pivoter le tirant 115 autour de son axe. Par exemple, la tête 125 présente une forme extérieure polyédrique, notamment hexagonale, ou encore une empreinte telle qu'une empreinte cruciforme destinée à accueillir un outil de manoeuvre du tirant 115.

Une deuxième extrémité 132 du tirant 115, opposée à la première extrémité, présente un filetage configuré pour coopérer avec un filetage correspondant de l'organe complémentaire 120 correspondant.

Chaque organe complémentaire 120 est, par exemple, une bague fixée au panneau 25, notamment fixée au châssis 70, en particulier à la portion principale 85, et délimitant un trou taraudé traversant l'organe complémentaire 120 et le panneau 25 selon la direction principale X.

Ainsi, chaque tirant 115, lorsqu'il pivote autour de son axe, coopère via les taraudages précités avec le panneau 25 pour déplacer le panneau 25 entre les première et deuxième positions. En particulier, la rotation du tirant 115 permet d'écarter ou de rapprocher l'organe complémentaire 120 correspondant, et donc le panneau 25, de la tête 125 et donc du premier pilier 60A.

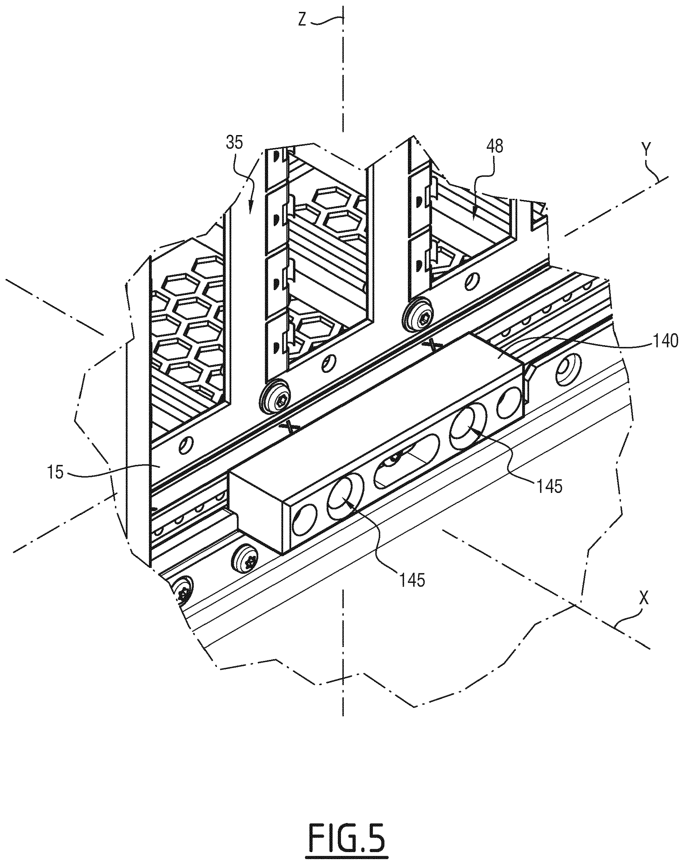

De manière additionnelle, la baie 10 comporte en outre, de manière facultative mais préférée, au moins un dispositif de centrage 130, notamment une pluralité de dispositifs de centrage 130, dont l'un est représenté en détails sur les figures 5 à 8.

Chaque dispositif de centrage 130 est configuré pour assurer un alignement du tiroir 15 et du panneau 25 lorsque le tiroir 15 est dans la position insérée et le panneau 25 est déplacé depuis la première position jusqu'à la deuxième position. Par exemple, chaque dispositif de centrage 130 est configuré pour assurer un positionnement relatif prédéterminé du panneau 25 par rapport au tiroir 15 dans un plan perpendiculaire à la direction principale X.

En particulier, chaque dispositif de centrage 130 est configuré pour assurer l'alignement de chaque premier connecteur 50 avec chaque deuxième conducteur 55 lorsque le tiroir 15 est dans la position insérée et le panneau 25 est déplacé depuis la première position jusqu'à la deuxième position.

Chaque dispositif de centrage 130 comporte, par exemple, au moins un élément mâle 135 et un élément femelle 140 correspondant.

Chaque élément mâle 135 s'étend selon la direction principale X et est destiné à être accueilli dans une ouverture correspondante 145 de l'élément femelle 140. Chaque ouverture 145 s'étend selon la direction principale X.

Les éléments mâles 135 sont, par exemple, au nombre de 12, toutefois ce nombre est susceptible de varier.

Le nombre d'éléments mâles 135 est, notamment, supérieur ou égal à 2, par exemple strictement supérieur à 2.

Chaque élément mâle 135 est, par exemple, solidaire du panneau 25, notamment fixé à une face avant du châssis 70, en particulier à une face de la portion principale 85, cette face étant en regard du tiroir 15 lorsque le tiroir 15 est dans la position insérée.

Le panneau 25 comporte, par exemple, deux sous-ensembles d'éléments mâles 135, chaque deuxième connecteur 55 étant interposé selon le direction verticale Z entre les deux sous-ensembles.

Une distance selon la direction transversale Y entre deux éléments mâles 135 consécutifs est, par exemple, comprise entre 40 mm et 200 mm.

Les éléments mâles 135 de chaque sous-ensemble sont, par exemple, disposés successivement

Chaque élément mâle 135 présente une première portion 150 et une deuxième portion 155.

La première portion 150 est solidaire du panneau 25. Par exemple, la première portion 150 est en appui contre le panneau 25, notamment contre le châssis 70, et solidarisée au panneau 25 par une vis traversant le panneau 25 et coopérant avec un filetage de la première portion 150. En variante, la première portion 150 est soudée au panneau 25.

La deuxième portion 155 est prévue pour être engagée dans l'ouverture 145 correspondante. En particulier, la deuxième portion 155 est configurée pour être engagée dans l'ouverture 145 lorsque le tiroir 15 est dans la position insérée et le panneau 25 est dans la deuxième position, et pour être entièrement hors de l'ouverture 145 lorsque le tiroir 15 est dans la position insérée et le panneau 25 est dans la première position.

En particulier, la deuxième portion 155 s'étend selon la direction principale X depuis la première portion 150 vers l'avant de la baie 10, donc en direction du tiroir 15 lorsque le tiroir 15 est dans la position insérée. Par exemple, la deuxième portion 155 est sensiblement cylindrique. La deuxième portion 155 présente un troisième diamètre compris entre 6 mm et 10 mm.

La deuxième portion 155 présente, notamment, un chanfrein à son extrémité dirigée vers le tiroir 15. En d'autres termes, l'extrémité de la deuxième portion 155 opposée à la première portion 150 présente un diamètre strictement inférieur au troisième diamètre, notamment un diamètre variant linéairement sur une partie terminale de la deuxième portion 155.

Chaque élément femelle 140 est solidaire du tiroir 15, par exemple fixé à la face arrière 35. Par exemple, chaque élément femelle 140 est vissé à la face arrière 35, ou encore soudé à la face arrière 35.

Chaque élément femelle 140 délimite au moins une ouverture 145 destinée à accueillir un élément mâle 135 correspondant, notamment destinée à accueillir la deuxième portion 155. Par exemple, chaque élément femelle 140 délimite deux ouvertures 145 décalées l'une par rapport à l'autre selon la direction transversale Y.

Les éléments femelles 140 sont, par exemple, au nombre de 6, toutefois ce nombre est susceptible de varier.

Chaque ouverture 145 s'étend selon la direction principale X lorsque le tiroir 15 est dans la position insérée.

Chaque ouverture 145 est, par exemple, cylindrique. Chaque ouverture 145 présente un quatrième diamètre compris par exemple entre 6 mm et 10 mm.

Chaque ouverture 145 débouche sur une face de l'élément femelle 140 correspondant, cette face étant en regard du panneau 25, donc dirigée vers l'arrière de la baie 10.

Chaque ouverture 145 présente par exemple un chanfrein à son extrémité débouchant sur la face arrière de l'élément femelle 140. En d'autres termes, l'extrémité de l'ouverture 145 débouchant sur la face arrière présente un diamètre strictement supérieur au quatrième diamètre, notamment un diamètre augmentant, par exemple linéairement, en se rapprochant de l'extrémité arrière de l'élément femelle 140.

Le fonctionnement de la baie 10 va maintenant être décrit.

Lors d'une étape initiale, le tiroir 15 est à l'extérieur de la baie 10 et le panneau 25 est dans la première position.

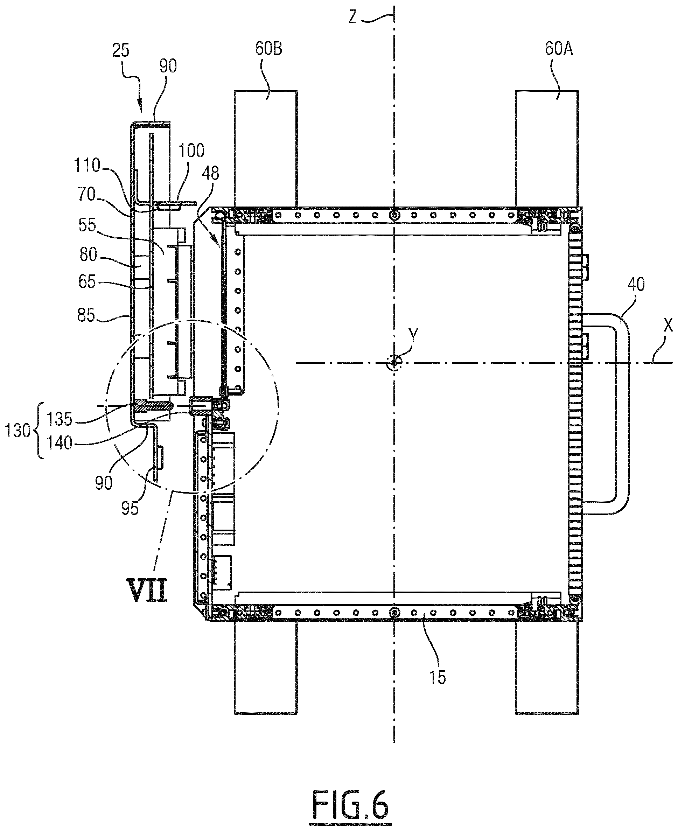

Lors d'une première étape, le tiroir 15 est mis en place dans la baie 10, c'est-à-dire dans le support 20 par un mouvement de translation de l'avant vers l'arrière selon la direction principale X. A l'issue de la première étape, le tiroir 15 est dans la position insérée. Puisque le panneau 25 est dans la première position, chaque deuxième connecteur 55 est déconnecté du premier connecteur 50 correspondant et chaque élément mâle 135 est entièrement hors de l'ouverture 145 correspondante, comme visible sur la figure 6.

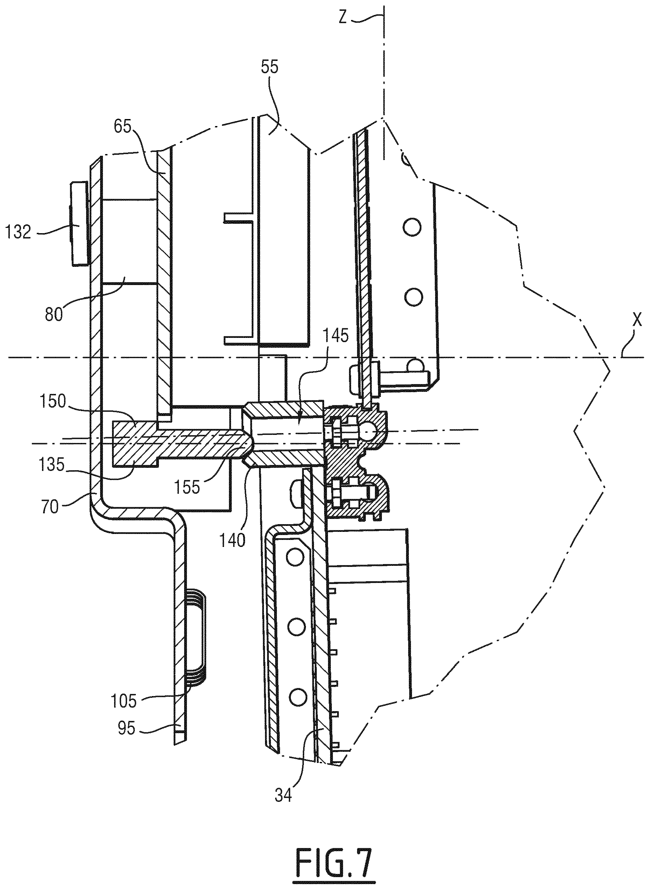

Lors d'une deuxième étape, un opérateur fait pivoter chaque tirant 115 autour de son axe, par exemple à l'aide d'un outil complémentaire de la tête 125. La rotation de chaque tirant rapproche le panneau 25 des premiers piliers 60A. En particulier, suite au déplacement du panneau 25, l'extrémité chanfreinée de la deuxième portion 155 de chaque élément mâle 135 pénètre dans l'ouverture 145 correspondante. Notamment, l'extrémité chanfreinée d'au moins une deuxième portion 155 entre en contact avec le chanfrein de l'ouverture 145 correspondante, comme visible sur la figure 7.

Lors de la troisième étape, l'opérateur continue à faire pivoter chaque tirant 115 jusqu'à amener le panneau 25 dans la deuxième position. Au cours de ce déplacement, les deuxièmes portions 155 pénètrent plus profondément dans les ouvertures 145 correspondantes.

Grâce à l'invention, les connecteurs 55 portés par le panneau 25 sont connectés au tiroir 15 en déplaçant le panneau 25, le tiroir 15 étant dans sa position insérée. Les forces mises en jeu sont donc moindres que les forces nécessaires à déplacer le tiroir 15 lui-même, ce qui limite les risques d'endommagement des différents connecteurs 50, 55.

Les tirants 115 permettent de déplacer simplement le panneau entre ses première et deuxième positions depuis l'avant de la baie 10. Pour cela, des tirants filetés permettent une bonne précision de déplacement tout en restant simples à mettre en oeuvre.

Le déplacement du panneau 25 est plus précis lorsqu'au moins deux tirants 25 encadrant le tiroir 15 selon la direction transversale Y sont utilisés. Lorsque quatre tirants 25 disposés aux sommets d'un rectangle sont utilisés, le déplacement du panneau 25 est encore plus précis.

Un jeu supérieur ou égal à 1 mm, notamment compris entre 2 et 4 mm, entre le panneau 25 dans sa première position et le support 20 permet de limiter les contraintes sur les connecteurs 50, 55 lors de leur connexion. Pour cela, une différence de diamètre entre les tirants 115 et les trous correspondants permet par exemple d'obtenir aisément un jeu propre à limiter les contraintes sur les connecteurs 50, 55.

Les éjecteurs 75 permettent d'assurer une déconnexion douce des connecteurs 50, 55 lorsque les tirants sont pivotés de manière à éloigner le panneau 25 des premiers piliers 60A. En particulier, ils empêchent que le panneau 25 reste dans sa deuxième position lors de la manoeuvre des tirants et que le retrait du tiroir 15 hors du support 20 génère des contraintes sur les connecteurs 50, 55.

Les dispositifs de centrage 130 permettent d'assurer un bon positionnement relatif dans un plan perpendiculaire à la direction principale X entre le tiroir 15 et le panneau 25 malgré les éventuels jeux mécaniques et/ou désorientations relatives susceptibles d'être présents.

La solidarisation des éléments femelles 140 et non des éléments mâles 135 au tiroir 15 permet de réduire les risques d'endommagement de la baie 10. En effet, les éléments femelles 140 sont moins fragiles que les éléments mâles 135 et donc moins susceptibles d'endommagement que ceux-ci. Puisque le tiroir 15, étant extractible de la baie 10, est plus susceptible que le panneau 25 (qui n'est pas extractible) de subir des chocs, il est donc préférable que les éléments femelles soient montés sur le tiroir 15.

Des pistes de connexion portées par le panneau 65 permettent de relier entre eux des modules électroniques 37 sans utiliser de conducteurs externes additionnels qui requièrent une place importante et sont complexes à mettre en place.

## Revendications

1. Baie électronique (10) comportant un support (20) et un panneau (25), le support (20) étant configuré pour accueillir un tiroir (15) et pour guider le tiroir (15) en translation selon une direction principale (X) lorsque le tiroir (15) est accueilli dans le support (20), un avant et un arrière étant définis pour la direction principale (X), le tiroir (15) étant prévu pour être inséré dans le support (20) de l'avant vers l'arrière jusqu'à une position insérée, le tiroir (15) présentant une face avant (30) et une face arrière (35) délimitant le tiroir (15) selon la direction principale (X), le panneau (25) étant disposé en regard de la face arrière (35) du tiroir (15) lorsque le tiroir (15) est dans la position insérée,
la baie (10) comportant un ensemble de premiers connecteurs (55), chaque premier connecteur (55) étant configuré pour être connecté à un deuxième connecteur (50) d'un module électronique (37) accueilli dans le tiroir (15) lorsque le tiroir (15) est dans la position insérée,
la baie (10) étant **caractérisée en ce qu'**elle comporte des moyens (27) de déplacement du panneau (25) selon la direction principale (X) par rapport au support (20) entre une première position et une deuxième position, chaque premier connecteur (55) étant porté par le panneau (25), chaque premier connecteur (55) étant déconnecté du deuxième connecteur (50) correspondant lorsque le panneau (25) est dans la première position et le tiroir (15) est dans la position insérée, chaque premier connecteur (55) étant connecté au deuxième connecteur (50) correspondant lorsque le panneau (25) est dans la deuxième position et le tiroir (15) est dans la position insérée.

2. Baie selon la revendication 1, dans laquelle les moyens de déplacement (27) comportent au moins un tirant (115) s'étendant parallèlement à la direction principale (X) et configuré pour exercer sur le panneau (25) et sur le support (20) une force tendant à déplacer le panneau (25) de la première position à la deuxième position.

3. Baie selon la revendication 2, comportant au moins une paire de tirants (115), le tiroir (15) étant interposé dans un plan perpendiculaire à la direction principale (X) entre les deux tirants (115) lorsque le tiroir (15) est dans la position insérée.

4. Baie selon la revendication 3, comportant au moins deux paires de tirants (115), chaque tirant (115) étant disposé à un sommet correspondant d'un unique rectangle perpendiculaire à la direction principale (X).

5. Baie selon l'une quelconque des revendications 2 à 4, dans laquelle le ou chaque tirant (115) s'étend selon un axe parallèle à la direction principale (X) et comporte un filetage configuré pour coopérer avec le panneau (25) pour déplacer le panneau (25) entre les première et deuxième positions lorsque le tirant (115) pivote autour de son axe.

6. Baie selon l'une quelconque des revendications 1 à 5, dans laquelle un jeu mécanique du panneau (25) par rapport au support (20), selon une direction perpendiculaire à la direction principale (X), lorsque le panneau (25) est dans la première position, est supérieur ou égal à 1 millimètre, notamment compris entre 2 millimètres et 4 millimètres.

7. Baie selon la revendication 6, dans laquelle un premier diamètre est défini pour chaque tirant (115), chaque tirant (115) étant partiellement accueilli dans au moins un trou traversant une portion (60A, 60B) du support (20) selon la direction principale (X), le trou présentant un deuxième diamètre, une différence entre le premier et le deuxième diamètres étant supérieure ou égale à 1 millimètre, notamment comprise entre 2 millimètres et 4 millimètres.

8. Baie selon l'une quelconque des revendications 1 à 7, comportant au moins un organe élastique configuré pour exercer sur le panneau (25) une force tendant à déplacer le panneau (25) de la deuxième position vers la première position, lorsque le panneau est dans la deuxième position.

9. Baie selon l'une quelconque des revendications 1 à 8, dans laquelle le panneau (25) comporte au moins une piste de connexion s'étendant sur une surface du panneau (25), la piste de connexion connectant électriquement entre eux deux premiers connecteurs (55).

10. Baie selon l'une quelconque des revendications 1 à 9, comportant en outre un tiroir (15) prévu pour être inséré dans le support (20) de l'avant vers l'arrière jusqu'à une position insérée, le tiroir (15) étant prévu pour accueillir au moins un module électronique (37).

11. Baie selon la revendication 10, comportant, en outre, au moins un dispositif de centrage (130) configuré pour assurer un alignement de chaque premier connecteur (55) avec le deuxième connecteur (50) correspondant lorsque le panneau (25) est dans la deuxième position et le tiroir (15) est dans la position insérée.

12. Baie selon la revendication 11, dans laquelle le dispositif de centrage (130) comporte un élément femelle (140) et un élément mâle (135) destiné à être inséré dans l'élément femelle (140) lorsque le panneau (25) est déplacé de la première à la deuxième positions, l'élément femelle (140) étant solidaire du tiroir (15), l'élément mâle (135) étant solidaire du panneau (25).

13. Véhicule, notamment véhicule de transport en commun, comportant une baie électronique (10) selon l'une quelconque des revendications 1 à 12.

## Patentansprüche

1. Elektronikschrank (10) mit einem Träger (20) und einer Platte (25), wobei der Träger (20) konfiguriert ist zum Aufnehmen einer Schublade (15) und zum Führen der Schublade (15) in Translation entlang einer Hauptrichtung (X), wenn die Schublade (15) in dem Träger (20) aufgenommen ist, wobei eine Vorderseite und eine Rückseite für die Hauptrichtung (X) definiert sind, wobei die Schublade (15) dazu vorgesehen ist, in der Halterung (20) von vorne nach hinten bis in eine eingeführte Position eingeschoben zu werden. Die Schublade (15) weist eine Vorderseite (30) und eine Rückseite (35) auf, die die Schublade (15) in der Hauptrichtung (X) begrenzt, wobei die Platte (25) gegenüber der Rückseite (35) der Schublade (15) angeordnet ist, wenn sich die Schublade (15) in der eingeschobenen Position befindet,
der Schrank (10) einen Satz von ersten Verbindern (55) aufweist, wobei jeder erste Verbinder (55) so konfiguriert ist, dass er mit einem zweiten Verbinder (50) eines elektronischen Moduls (37) verbunden wird, das in der Schublade (15) aufgenommen ist, wenn sich die Schublade (15) in der eingeschobenen Position befindet,
wobei der Schrank (10) **dadurch gekennzeichnet ist, dass** er Mittel (27) zum Verschieben der Platte (25) in der Hauptrichtung (X) in Bezug auf den Träger (20) zwischen einer ersten Position und einer zweiten Position umfasst, wobei jeder erste Verbinder (55) von der Platte (25) getragen wird, wobei jeder erste Verbinder (55) von dem entsprechenden zweiten Verbinder (50) getrennt ist, wenn sich die Platte (25) in der ersten Position und die Schublade (15) in der eingeschobenen Position befindet, wobei jeder erste Verbinder (55) mit dem entsprechenden zweiten Verbinder (50) verbunden ist, wenn sich die Platte (25) in der zweiten Position und die Schublade (15) in der eingeschobenen Position befindet.

2. Schrank nach Anspruch 1, bei dem die Mittel (27) zum Verschieben mindestens eine Zugstange (115) umfassen, die sich parallel zur Hauptrichtung (X) erstreckt und so konfiguriert ist, dass sie auf die Platte (25) und den Träger (20) eine Kraft ausübt, die dazu tendiert, die Platte (25) von der ersten Position in die zweite Position zu verschieben.

3. Schrank nach Anspruch 2, mit mindestens einem Paar Zugstangen (115), wobei die Schublade (15) in einer Ebene senkrecht zur Hauptrichtung (X) zwischen den beiden Zugstangen (115) angeordnet ist, wenn sich die Schublade (15) in der eingeschobenen Position befindet.

4. Schrank nach Anspruch 3, mit mindestens zwei Paaren von Zugstangen (115), wobei jede Zugstange (115) an einem entsprechenden Scheitelpunkt eines einzelnen Rechtecks senkrecht zur Hauptrichtung (X) angeordnet ist.

5. Schrank nach einem der Ansprüche 2 bis 4, bei dem sich die oder jede Zugstange (115) entlang einer Achse parallel zur Hauptrichtung (X) erstreckt und ein Gewinde aufweist, das so konfiguriert ist, dass es mit der Platte (25) zusammenwirkt, um die Platte (25) zwischen der ersten und der zweiten Position zu verschieben, wenn die Zugstange (115) um ihre Achse schwenkt.

6. Schrank nach einem der Ansprüche 1 bis 5, wobei ein mechanisches Spiel der Platte (25) in Bezug auf den Träger (20) in einer Richtung senkrecht zur Hauptrichtung (X), wenn sich die Platte (25) in der ersten Position befindet, größer oder gleich 1 Millimeter ist, insbesondere zwischen 2 Millimetern und 4 Millimetern liegt.

7. Schrank nach Anspruch 6, bei dem ein erster Durchmesser für jede Zugstange (115) definiert ist, jede Zugstange (115) zumindest teilweise in einem Loch aufgenommen wird, das durch einen Abschnitt (60A, 60B) des Trägers (20) in Hauptrichtung (X) verläuft, das Loch hat einen zweiten Durchmesser, wobei ein Unterschied zwischen dem ersten und dem zweiten Durchmesser größer oder gleich 1 Millimeter ist, insbesondere zwischen 2 Millimetern und 4 Millimetern.

8. Schrank nach einem der Ansprüche 1 bis 7, mit mindestens einem elastischen Organ, das so konfiguriert ist, dass es auf die Platte (25) eine Kraft ausübt, die dazu neigt, die Platte (25) von der zweiten Position in die erste Position zu verschieben, wenn sich die Platte in der zweiten Position befindet.

9. Schrank nach einem der Ansprüche 1 bis 8, wobei die Platte (25) mindestens eine Verbindungsspur aufweist, die sich über eine Oberfläche der Platte (25) erstreckt, wobei die Verbindungsspur zwei erste Verbinder (55) elektrisch miteinander verbindet.

10. Schrank nach einem der Ansprüche 1 bis 9, der außerdem eine Schublade (15) umfasst, die dazu vorgesehen ist, von vorne nach hinten bis zu einer eingeschobenen Position in den Träger (20) eingeschoben zu werden, wobei die Schublade (15) dazu vorgesehen ist, mindestens ein elektronisches Modul (37) aufzunehmen.

11. Schrank nach Anspruch 10, der außerdem mindestens eine Zentriervorrichtung (130) aufweist, die so konfiguriert ist, dass sie eine Ausrichtung jedes ersten Verbinders (55) mit dem entsprechenden zweiten Verbinder (50) sicherstellt, wenn sich die Platte (25) in der zweiten Position und die Schublade (15) in der eingeschobenen Position befindet.

12. Schrank nach Anspruch 11, wobei die Zentriervorrichtung (130) ein weibliches Element (140) und ein männliches Element (135) umfasst, das dazu bestimmt ist, in das weibliche Element (140) eingefügt zu werden, wenn die Platte (25) von der ersten in die zweite Position verschoben wird. Das weibliche Element (140) ist fest mit der Schublade (15) verbunden, während das männliche Element (135) fest mit der Platte (25) verbunden ist.

13. Fahrzeug, insbesondere Fahrzeug für den öffentlichen Verkehr, mit einem Elektronikschrank (10) nach einem der Ansprüche 1 bis 12.

## Claims

1. An electronic rack (10) comprising a cabinet (20) and a panel (25), the cabinet (20) being configured to house a drawer (15) and to guide the drawer (15) translationally along a primary direction (X) when the drawer (15) is housed in the cabinet (20), a front and a rear being defined for the primary direction (X), the drawer (15) being provided to be inserted into the cabinet (20) from the front to the rear until it reaches an inserted position, the drawer (15) having a front face (30) and a rear face (35) delimiting the drawer (15) in the primary direction (X), the panel (25) being disposed across from the rear face (35) of the drawer (15) when the drawer (15) is in the inserted position,
the rack (10) comprising a set of first connectors (55), each first connector (55) being configured to be connected to a second connector (50) of an electronic module (37) housed in the drawer (15) when the drawer (15) is in the inserted position,
the rack (10) being **characterized in that** it comprises means (27) of moving the panel (25) in the primary direction (X) relative to the cabinet (20) between a first position and a second position, each first connector (55) being held by the panel (25), each first connector (55) being disconnected from the corresponding second connector (50) when the panel (25) is in the first position and the drawer (15) is in the inserted position, each first connector (55) being connected to the corresponding second connector (50) when the panel (25) is in the second position and the drawer (15) is in the inserted position.

2. A rack according to claim 1, wherein the means of moving (27) comprise at least one tie rod (115) extending parallel to the primary direction (X) and configured to exert on the panel (25) and on the cabinet (20) a force intended to move the panel (25) from the first position to the second position.

3. A rack according to claim 2, comprising at least a pair of tie rods (115), the drawer (15) being interposed in a plane perpendicular to the primary direction (X) between the two tie rods (115) when the drawer (15) is in the inserted position.

4. A rack according to claim 3, comprising at least two pairs of tie rods (115), each tie rod (115) being disposed at a vertex corresponding to a single rectangle perpendicular to the primary direction (X).

5. A rack according to any one of the claims 2 to 4, wherein the or each tie rod (115) extends along an axis parallel to the primary direction (X) and comprises threading configured to mate with the panel (25) to move the panel (25) between the first and second positions when the tie rod (115) pivots around its axis.

6. A rack according to any one of the claims 1 to 5, wherein a mechanical clearance between the panel (25) and the cabinet (20), in a direction perpendicular to the primary direction (X), when the panel (25) is in the first position, is greater than or equal to 1 millimeter, and particularly between 2 millimeters and 4 millimeters.

7. A rack according to claim 6, wherein a first diameter is defined for each tie rod (115), each tie rod (115) being partially housed in at least one hole passing through a portion (60A, 60B) of the cabinet (20) in the primary direction (X), the hole having a second diameter, a difference between the first and second diameters being greater than or equal to 1 millimeter, and particularly between 2 millimeters and 4 millimeters.

8. A rack according to any one of the claims 1 to 7, comprising at least one resilient member configured to exert a force intended to move the panel (25) from the second position to the first position, when the panel is in the second position.

9. A rack according to any one of the claims 1 to 8, wherein the panel (25) comprises at least one connection strip extending along a surface of the panel (25), the connection strip electrically connecting two first connectors (55) to one another.

10. A rack according to any one of the claims 1 to 9, further comprising a drawer (15) provided to be inserted into the cabinet (20) from the front to the rear until it reaches an inserted position, the drawer (15) being provided to house at least one electronic module (37).

11. A rack according to claim 10, further comprising at least one centering device (130) configured to ensure alignment of each first connector (55) with the corresponding second connector (50) when the panel (25) is in the second position and the drawer (15) is in the inserted position.

12. A rack according to claim 11, wherein the centering device (130) comprises a female part (140) and a male part (135) intended to be inserted into the female part (140) when the panel (25) is moved from the first to the second position, the female part (140) being rigidly connected to the drawer (15), the male part (135) being rigidly connected to the panel (25).

13. A vehicle, particularly a mass transit vehicle, comprising an electronic rack (10) according to any one of the claims 1 to 12.
